(19) Europäisches Patentamt
European Patent Office
Office européen des brevets

(11) **EP 4 246 150 B1**

(12) **EUROPÄISCHE PATENTSCHRIFT**

(45) Veröffentlichungstag und Bekanntmachung des Hinweises auf die Patenterteilung:
**11.09.2024 Patentblatt 2024/37**

(21) Anmeldenummer: **23160351.5**

(22) Anmeldetag: **07.03.2023**

(51) Internationale Patentklassifikation (IPC):
***G01R 27/02*** *(2006.01)* ***G01R 27/26*** *(2006.01)*
***G01R 31/52*** *(2020.01)*

(52) Gemeinsame Patentklassifikation (CPC):
**G01R 27/025; G01R 27/2605; G01R 31/52**

(54) **VERFAHREN UND ÜBERWACHUNGSEINRICHTUNG ZUR BESTIMMUNG EINES TEIL-ISOLATIONSWIDERSTANDS UND EINER TEIL-NETZABLEITKAPAZITÄT IN EINEM VERZWEIGTEN UNGEERDETEN STROMVERSORGUNGSSYSTEM**

METHOD AND MONITORING DEVICE FOR DETERMINING A PARTIAL INSULATION RESISTANCE AND A PARTIAL GRID DEVIATION CAPACITY IN A BRANCHED UNEARTHED POWER SUPPLY SYSTEM

PROCÉDÉ ET DISPOSITIF DE SURVEILLANCE POUR DÉTERMINER UNE RÉSISTANCE D'ISOLATION PARTIELLE ET UNE CAPACITÉ DE DÉRIVATION PARTIELLE DANS UN SYSTÈME D'ALIMENTATION ÉLECTRIQUE NON MIS À LA TERRE RAMIFIÉ

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **18.03.2022 DE 102022106394**

(43) Veröffentlichungstag der Anmeldung:
**20.09.2023 Patentblatt 2023/38**

(73) Patentinhaber: **Bender GmbH & Co. KG**
**35305 Grünberg (DE)**

(72) Erfinder: **HARTMANN, Carsten**
**63679 Schotten (DE)**

(74) Vertreter: **advotec.**
**Patent- und Rechtsanwaltspartnerschaft**
**Tappe mbB**
**Georg-Schlosser-Straße 6**
**35390 Gießen (DE)**

(56) Entgegenhaltungen:
EP-A1- 3 620 800   DE-B3- 102017 209 663
DE-B3- 102017 217 473   US-B2- 10 340 680

**Beschreibung**

Die Erfindung betrifft ein Verfahren und eine Überwachungseinrichtung zur selektiven Bestimmung eines Teil-Isolationswiderstands und einer Teil-Netzableitkapazität eines Leitungsabgangs in einem verzweigten ungeerdeten Stromversorgungssystem, das mit einem Isolationsüberwachungsgerät überwacht wird, welches dem ungeerdeten Stromversorgungssystem aktiv eine Mess-Wechselspannung, insbesondere eine Rechteckimpuls-förmige Messspannung, überlagert.

Für die Versorgung von elektrischen Betriebsmitteln kommt bei erhöhten Anforderungen an die Betriebs-, Brand und Berührungssicherheit die Netzform eines ungeerdeten Stromversorgungssystems zum Einsatz.

Bei dieser Netzform eines Stromversorgungssystems, welches auch als isoliertes Netz (frz. Isolé Terre - IT) oder IT-System bezeichnet wird, sind die aktiven Teile von dem Erdpotenzial - gegenüber Erde - getrennt. Der Vorteil dieser Netze liegt darin, dass bei einem ersten Isolationsfehler wie beispielsweise einem Erdschluss oder einem Körperschluss das Stromversorgungssystem weiterbetrieben werden kann, also die Funktion der elektrischen Betriebsmittel nicht beeinträchtigt wird, da sich wegen des im Idealfall unendlich großen Impedanzwertes zwischen den aktiven Leitern (Außenleiter/Phasenleiter und, falls mitgeführt, der Neutralleiter N) des Netzes und Erde in diesem ersten Fehlerfall kein geschlossener Stromkreis ausbilden kann.

Der elektrische Widerstand des ungeerdeten Stromversorgungssystems gegen Erde (Isolationswiderstand) wird daher ständig überwacht, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der elektrischen Anlage mit Betriebsstillstand zur Folge hätte.

Die Überwachung des ungeerdeten Stromversorgungssystems erfolgt gemäß der Norm IEC 61557-8 mit einem Isolationsüberwachungsgerät, das zwischen mindestens einem der aktiven Leiter des ungeerdeten Stromversorgungssystems und Erde angekoppelt wird. Dazu weist das normgemäße Isolationsüberwachungsgerät eine Messspannungsquelle auf, die dem Stromversorgungssystem zwischen dem/den aktiven Leiter(n) und Erde eine Messspannung aktiv überlagert. Als Messspannung wird dem Stand der Technik gemäß eine Mess-Wechselspannung und insbesondere als Sonderform der Mess-Wechselspannung eine Rechteckimpuls-förmige Messspannung (Impuls-Messverfahren) verwendet. Eine Verschlechterung des Isolationszustandes spiegelt sich durch den von der Messspannung getriebenen und ansteigenden Messstrom wider. Der Isolationswiderstand wird in dem Isolationsüberwachungsgerät ermittelt, angezeigt und kann an weitere Überwachungseinheiten übermittelt werden. Bei Unterschreitung eines bestimmten Grenzwertes erfolgt eine Alarmmeldung.

Neben der Überwachung des Isolationswiderstandes kommt auch der Prüfung der Netzableitkapazitäten eine erhöhte Bedeutung zu, da die elektrische Anlage, insbesondere die Schutzleitererdung der angeschlossenen Betriebsmittel, durch die kapazitiven Ableitströme der Netzableitkapazitäten zusätzlich belastet wird. Zudem können sich die Netzableitkapazitäten in der Summe infolge unterschiedlicher Betriebsbedingungen ändern. Um Fehlerquellen zu erkennen und mögliche Überlastungen auszuschließen erscheint eine Überwachung der Netzableitkapazitäten vorteilhaft.

Allerdings erlaubt die Überwachung des Isolationswiderstands und der Netzableitkapazität der gesamten elektrischen Anlage - des ungeerdeten Stromversorgungssystems einschließlich der daran angeschlossenen Verbraucher -, also der Gesamt-Isolationswiderstand und die Gesamt-Netzableitkapazität, keine Aussage darüber, in welchem Leitungsabgang des verzweigten ungeerdeten Stromversorgungssystems der jeweilige Teil-Isolationswiderstand einen zulässigen Grenzwert unterschritten hat oder welche jeweilige Teil-Netzableitkapazität einen Grenzwert überschritten hat.

Dem Stand der Technik gemäß wird daher zu Identifikation des fehlerhaften Leitungsabgangs in dem verzweigten ungeerdeten Stromversorgungssystem nach der Meldung eines ersten Fehlers durch das Isolationsüberwachungsgerät eine Isolationsfehlersuche gestartet.

Eine Isolationsfehlersucheinrichtung umfasst im Wesentlichen einen Prüfstromgenerator und mehrere in den Leitungsabgängen angeordnete, meist als Messstromwandler ausgeführte, Prüfstromsensoren, die zur Auswertung der Messsignale mit einem Auswertegerät verbunden sind.

Der jeweilige in dem Leitungsabgang fließende Prüfstrom wird dabei von allen Messstromwandlern, die in dem Prüfstromkreis (Fehlerstromkreis) liegen, erfasst und in dem Auswertegerät ausgewertet und angezeigt. Durch die bekannte Zuordnung der Messstromwandler zu den Leitungsabgängen kann der Fehlerort lokalisiert werden.

Um vorausschauend einen kritischen Leitungsabgang identifizieren zu können und damit bei Auftreten eines zweiten Fehlers einer möglichen Abschaltung der gesamten elektrischen Anlage zuvorzukommen, ist die selektive Bestimmung eines nur in dem möglicherweise kritischen Leitungsabgang wirksamen Teil-Isolationswiderstands und einer in diesem Leitungsabgang wirksamen Teil-Netzableitkapazität erforderlich.

Aus der Patentschrift DE 10 2017 217 473 B3 ist ein Verfahren zur selektiven Bestimmung eines Teil-Isolationswiderstands und einer Teil-Netzableitkapazität bekannt. Der Teil-Isolationswiderstand und die Teil-Netzableitkapazität werden dort mittels eines von einer erweiterten Isolationsfehlersucheinrichtung eingespeisten Prüfstroms bestimmt. Als Nachteil erweist sich dabei, dass dieser Prüfstrom zusätzlich zu dem Messstrom eines Isolationsüberwachungssystems eingespeist werden muss oder dass der Messstrom-Generator des Isolationsüberwachungssystems zwischen wechselnden Betriebsarten - Messstrom/Prüfstrom - umschaltbar ausgeführt sein muss.

Der vorliegenden Erfindung liegt somit die Aufgabe zu Grunde, ein Verfahren und eine Vorrichtung zur selektiven Bestimmung eines Teil-Isolationswiderstands und einer Teil-Netzableitkapazität eines Leitungsabgangs in einem verzweigten ungeerdeten Stromversorgungssystem anzugeben, wobei das Verfahren schaltungstechnisch effizient umsetzbar ist und die Vorrichtung nachrüstbar vorhandene Überwachungseinrichtungen ergänzt.

Im Hinblick auf ein Verfahren zur selektiven Bestimmung des Teil-Isolationswiderstands Rx eines Leitungsabgangs wird die Aufgabe gelöst durch Berechnen des Teil-Isolationswiderstands Rx gemäß Rx=Ue/Ixstat mit einer über dem Leitungsabgang abfallenden, stationären Leiter-Erde-Spannung Ue und einem in dem Leitungsabgang gemessenen stationären Teilstrom Ixstat im eingeschwungenen Zustand, wobei für die stationäre Leiter-Erde-Spannung Ue gilt Ue=Iges*Rfges mit einem von dem Isolationsüberwachungsgerät übermittelten Gesamt-Isolationswiderstand Rfges und einem von der bekannten Rechteckimpuls-förmigen Messspannung Uq getriebenen Gesamt-Messstrom Iges, wobei der Gesamt-Messstrom Iges berechnet wird aus Iges=Uq/(Rfges+Ri) mit dem bekannten Innenwiderstand Ri des Isolationsüberwachungsgerätes, sodass der Teil-Isolationswiderstand Rx berechnet wird aus

$$Rx = (Rfges*Uq)/((Rfges+Ri)*Ixstat).$$

Ausgangspunkt der Berechnung des Teil-Isolationswiderstands Rx ist das ohmsche Gesetz, wonach sich der Teil-Isolationswiderstand Rx eines bestimmten Leitungsabgangs aus der über diesem Leitungsabgang abfallenden, stationären Leiter-Erde-Spannung Ue und dem in diesem Leitungsabgang gemessenen stationären Teilstrom Ixstat ergibt. Beide Größen, die stationäre Leiter-Erde-Spannung Ue sowie der stationäre Teilstrom Ixstat, werden nach Abklingen der Ausgleichsvorgänge im eingeschwungenen Zustand betrachtet.

Mit dem von dem - voraussetzungsgemäß installierten - Isolationsüberwachungsgerät übermittelten Gesamt-Isolationswiderstand Rfges und dem bekannten Innenwiderstand Ri des Isolationsüberwachungsgerätes wird der von der bekannten Rechteckimpuls-förmigen Messspannung Uq des Isolationsüberwachungsgerätes getriebene Gesamt-Messstrom Iges berechnet.

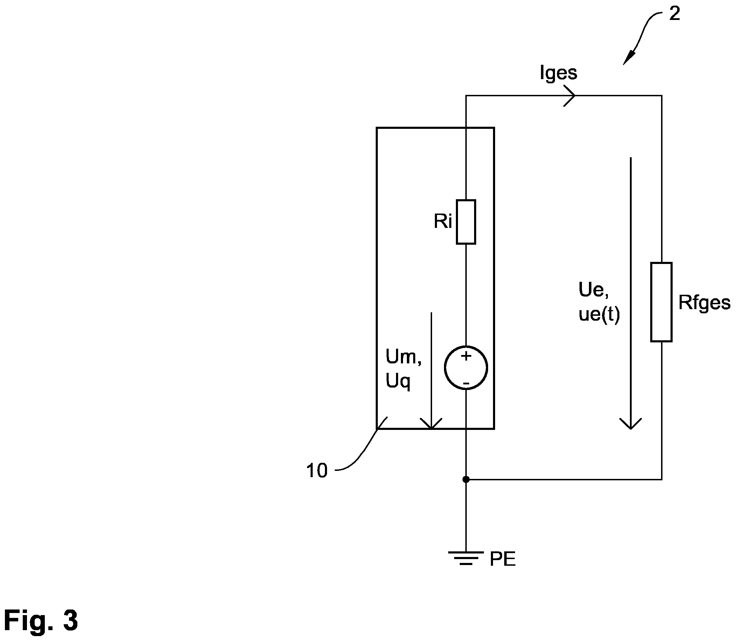

Ein Maschenumlauf (zweite Kirchhoffsche Regel, siehe Fig. 3) ergibt, dass die stationäre Leiter-Erde-Spannung Ue durch den Gesamt-Isolationswiderstands Rfges und den Gesamt-Messstrom Iges ausgedrückt werden kann und der Gesamt-Messstrom Iges weiter auf die bekannten Größen Rechteckimpuls-förmige Messspannung Uq und Innenwiderstand Ri des Isolationsüberwachungsgerätes zurückgeführt wird.

Eine Messung des Gesamt-Messstroms Iges sowie der stationären Leiter-Erde-Spannung Ue ist nicht erforderlich. Stattdessen ergibt sich der Teil-Isolationswiderstand Rx in vorteilhafter Weise aus den bekannten Kenngrößen Rechteckimpuls-förmige Messspannung Uq und Innenwiderstand Ri des Isolationswiderstandsgerätes sowie aus dem, von dem Isolationsüberwachungsgerät standardmäßig berechneten und übermittelten, Gesamt-Isolationswiderstand Rfges und dem in dem betreffenden Leitungsabgang gemessenen stationären Teilstrom Ixstat in eingeschwungenem Zustand.

Im Hinblick auf ein Verfahren zur selektiven Bestimmung der Teil-Netzableitkapazität Cx eines Leitungsabgangs wird die Aufgabe gelöst durch Ermitteln eines Teil-Isolationswiderstand Rx des Leitungsabgangs, Berechnen der Teil-Netzableitkapazität Cx gemäß Cx=ic(t)/(due(t)/dt), mit einem über die Teil-Netzableitkapazität Cx fließenden Ableitstrom ic(t) und einem zeitlichen Verlauf der über dem Leitungsabgang abfallenden, gemessenen nicht stationären Leiter-Erde-Spannung ue(t), deren zeitliche Ableitung due(t)/dt ist, wobei der Ableitstrom ic(t) berechnet wird aus ic(t)=ix(t)-ue(t)/Rx mit einem zeitlichen Verlauf des in dem Leitungsabgang gemessenen nicht stationären Teilstroms ix(t) und dem ermittelten Teil-Isolationswiderstand Rx, sodass die Teil-Netzableitkapazität Cx berechnet wird aus

$$Cx = (ix(t)-(ue(t)/Rx))/(due(t)/dt).$$

Die Berechnung der Teil-Netzableitkapazität Cx beruht auf der grundlegenden physikalischen Erkenntnis, dass der über die Teil-Netzableitkapazität Cx fließende Ableitstrom ic(t) in seinem zeitlichen Verlauf abhängig ist von der zeitliche Änderung (d/dt) der über der Teil-Netzableitkapazität Cx abfallenden, gemessenen nicht stationären Leiter-Erde-Spannung ue(t).

Andererseits ergibt sich gemäß der Knotenpunktsregel (erste Kirchhoffsche Regel) der über die Teil-Netzableitkapazität Cx fließende Ableitstrom ic(t) aus der Differenz des in dem Leitungsabgang gemessenen nicht stationären Teilstroms ix(t) und dem über den Teil-Isolationswiderstand Rx fließenden ohmschen Stromanteil. Mit dem zuvor ermittelten Teil-Isolationswiderstand Rx, dem gemessenen nicht stationären Teilstrom ix(t), und der gemessenen nicht stationären Leiter-Erde-Spannung ue(t) sowie mit deren zeitlichen Ableitung due(t)/dt kann somit die Teil-Netzableitkapazität Cx berechnet werden zu

$$Cx=(ix(t)-(ue(t)/Rx))/(due(t)/dt).$$

Bezogen auf eine Vorrichtung wird die Aufgabe gelöst durch einen allstromsensitiven Messstromwandler zur Messung eines stationären Teilstroms Ixstat und eines nicht stationären Teilstroms ix(t) in jedem zu überprüfenden Leitungsabgang, ein Spannungsmessgerät, das zwischen einen aktiven Leiter des ungeerdeten Stromversorgungssystems und Erde zur Messung des zeitlichen Verlaufs der nicht stationären Leiter-Erde-Spannung ue(t) geschaltet ist und eine Auswerteeinheit, die mit den allstromsensitiven Messstromwandlern und mit dem Isolationsüberwachungsgerät verbunden ist und konfiguriert ist zum Berechnen des Teil-Isolationswiderstands Rx und der Teil-Netzableitkapazität Cx.

Die Umsetzung der zuvor beschriebenen Verfahren zur selektiven Bestimmung des Teil-Isolationswiderstands Rx und der Teil-Netzableitkapazität Cx erfolgt mittels einer Überwachungseinrichtung, die neben einem bekannten, normgerechten Isolationsüberwachungsgerät, welches konfiguriert ist, dem Stromversorgungssystem aktiv eine Mess-Wechselspannung Um zu überlagern, erfindungsgemäß einen allstromsensitiven (Typ B) Messstromwandler in jedem Leitungsabgang, ein Spannungsmessgerät sowie eine Auswerteeinheit aufweist.

Die jeweiligen allstromsensitiven Messstromwandler messen in jedem zu überprüfenden Leitungsabgang zur Bestimmung des Teil-Isolationswiderstands Rx im eingeschwungenen Zustand den stationären Teilstrom Ixstat sowie zur Bestimmung der Teil-Netzableitkapazität Cx den zeitlichen Verlauf des nicht stationären Teilstrom ix(t).

Mit dem Spannungsmessgerät wird der zeitliche Verlauf der nicht stationären Leiter-Erde-Spannung ue(t) zwischen einem aktiven Leiter und Erde erfasst.

Die Auswerteeinheit ist mit dem Isolationsüberwachungsgerät durch eine Kommunikationsleitung zur Übermittlung des von dem Isolationsüberwachungsgerät bereitgestellten Gesamt-Isolationswiderstands Rfges sowie mit den allstromsensitiven Messstromwandlern über Signalleitungen verbunden. Sämtliche Berechnungsvorgänge erfolgen in der Auswerteeinheit.

Mit Vorteil ist das Isolationsüberwachungsgerät konfiguriert, dem Stromversorgungsystem als Mess-Wechselspannung Um zum Berechnen des Teil-Isolationswiderstands Rx eine Rechteckimpuls-förmige Messspannung Uq zu überlagern.

Um den stationären Teilstrom Ixstat zu erfassen überlagert das Isolationsüberwachungsgerät die Mess-Wechselspannung Um in Form einer Rechteckimpuls-förmigen Messspannung Uq. Die Dauer der einzelnen Rechteckimpulse ist dabei hinreichend lang, sodass nach einer Einschwingphase, in welcher die Netzableitkapazitäten auf-/entladen werden, ein eingeschwungener (stationärer) Zustand eintritt, in dem der (rein ohmsche) stationäre Teilstrom Ixstat erfassbar ist.

In weiterer Ausgestaltung sind die Messstromwandler installierte Messstromwandler einer Isolationsfehlersucheinrichtung.

Da eine Vielzahl der installierten ungeerdeten Stromversorgungssysteme bereits mit einer Isolationsfehlersucheinrichtung ausgestattet ist, welche an den Leitungsabgängen angeordnete Messstromwandler aufweist, ist es von Vorteil, diese Messstromwandler allstromsensitiv auszuführen und zum Erfassen des in dem jeweiligen Leitungsabgang fließenden stationären Teilstroms Ixstat und des nicht stationären Teilstrom ix(t) zu nutzen, um den jeweiligen Teil-Isolationswiderstand Rx und die jeweilige Teil-Netzableitkapazität Cx bestimmen zu können.

Mit Vorteil ist die Auswerteeinheit ein Auswertegerät der Isolationsfehlersucheinri chtung.

Ebenso wie die Messstromwandler kann auch ein bereits in dem ungeerdeten Stromversorgungssystem vorhandenes Auswertegerät der Isolationsfehlersucheinrichtung zur Berechnung des Teil-Isolationswiderstands Rx und der Teil-Netzableitkapazität Cx verwendet werden.

Der Teil-Isolationswiderstand Rx und die Teil-Netzableitkapazität Cx können erfindungsgemäß kontinuierlich überwacht werden, ohne dass vorhandene Überwachungssysteme ab- oder umgeschaltet werden müssen oder deren Betriebsmodus gewechselt werden muss. So ist es beispielsweise bei dem installierten Isolationsüberwachungsgerät nicht erforderlich, von der Betriebsart Isolationsüberwachung (Messstrom-Einspeisung zur Bestimmung des Gesamt-Isolationswiderstands) zur Betriebsart Isolationsfehlersuche (Prüfstrom-Einspeisung für die Bestimmung des fehlerhaften Leitungsabgangs) überzugehen. Ein vorhandenes normgerechtes Isolationsüberwachungsgerät kann unabhängig von der erfindungsgemäßen Überwachungseinrichtung arbeiten, aber in vorteilhafter Weise durch die Erfindung in seinem Funktionsumfang erweitert werden.

Weitere vorteilhafte Ausgestaltungsmerkmale ergeben sich der nachfolgenden Beschreibung und den Zeichnungen, die eine bevorzugte Ausführungsform der Erfindung anhand von Beispielen erläutern.

Es zeigen:

**Fig. 1** Ein verzweigtes ungeerdetes Stromversorgungssystem mit Isolationsüberwachung und Isolationsfehlersucheinrichtung,

**Fig. 2** ein Ersatzschaltbild des verzweigten ungeerdeten Stromversorgungssystems mit erfindungsgemäßer Überwachungseinrichtung und

Fig. 3    ein vereinfachtes Ersatzschaltbild des verzweigten ungeerdeten Stromversorgungssystems mit Gesamt-Isolationswiderstand.

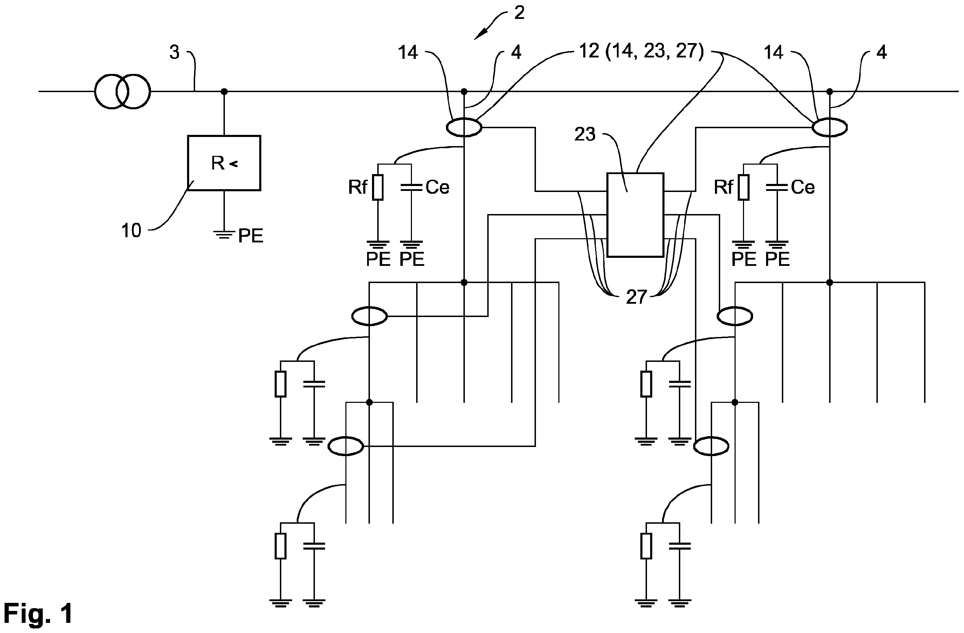

**Fig. 1** zeigt exemplarisch die Topologie eines verzweigten ungeerdeten Stromversorgungssystems 2. Das ungeerdete Stromversorgungssystem 2 weist mehrere von einem Hauptsystem 3 ausgehende Leitungsabgänge 4 auf. Jeder Leitungsabgang 4 sowie die weiteren von diesem Leitungsabgang abgehenden Verzweigungen weisen (Teil-)Isolationswiderstände Rf und (Teil-)Netzableitkapazitäten Cf gegen Erde auf - aus zeichentechnischen Gründen sind diese Isolationswiderstände Rf und Netzableitkapazitäten Ce nur für die erste Ebene der Leitungsabgänge bezeichnet.

Zur Isolationsüberwachung ist ein normgerechtes Isolationsüberwachungsgerät 10 vorgesehen, welches dem verzweigten ungeerdeten Stromversorgungssystem 2 aktiv eine Messspannung überlagert. Der sich einstellende Messstromkreis über die aktiven Leiter des ungeerdeten Stromversorgungssystems 2, über die Isolationswiderstände Rf und Netzableitkapazitäten Ce und Erde zurück zu dem Isolationsüberwachungsgerät 10 wird in dem Isolationsüberwachungsgerät 10 ausgewertet und liefert eine Aussage über die Größe des (Gesamt-)Isolationswiderstands der elektrischen Anlage.

Unterschreitet der Isolationswiderstand einen bestimmten Grenzwert, erfolgt eine Alarmmeldung und mittels einer Isolationsfehlersucheinrichtung 12 wird eine Isolationsfehlersuche gestartet, um den fehlerhaften Leitungsabgang zu identifizieren. Die Isolationsfehlersucheinrichtung 12 umfasst dazu in jedem zu überwachenden Leitungsabgang 4 angeordnete Messstromwandler 14, deren Messsignale über Signalleitungen 27 an ein Auswertegerät 23 in der Isolationsfehlersucheinrichtung 12 weitergeleitet werden.

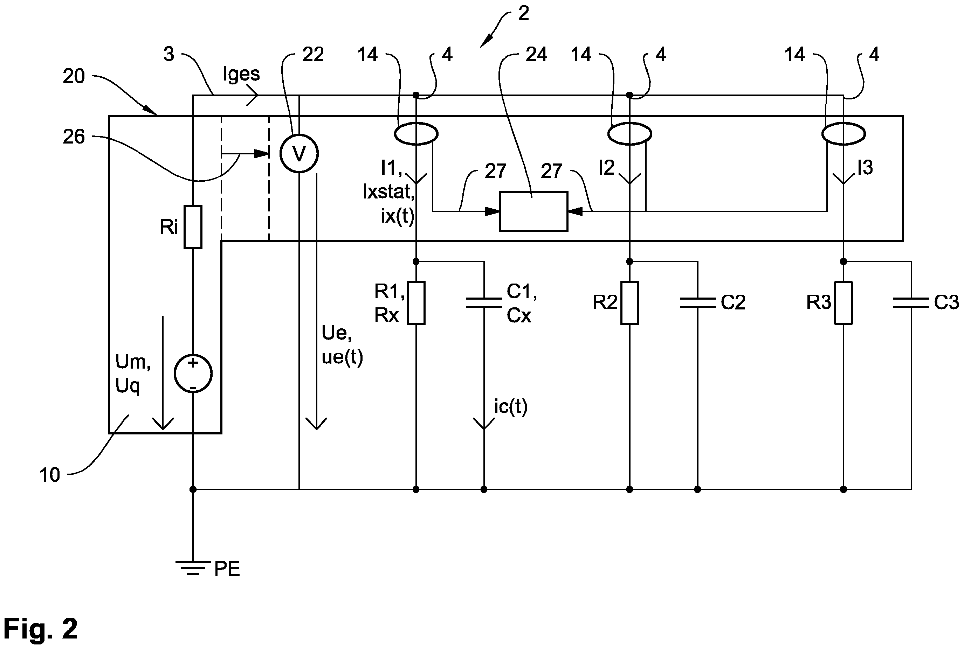

**Fig. 2** zeigte ein Ersatzschaltbild des verzweigten ungeerdeten Stromversorgungssystems 2 mit erfindungsgemäßer Überwachungseinrichtung 20.

Das Stromversorgungssystem 2 bildet eine Anwendungsumgebung (nicht Bestandteil der Erfindung) für die erfindungsgemäße Überwachungseinrichtung 20 und umfasst das Hauptsystem 3 und mit exemplarisch drei Leitungsabgängen 4.

Die Leitungsabgänge 4 weisen jeweils gegenüber Erde PE die Teil-Isolationswiderstände R1, R2 und R3 sowie Teil-Netzableitkapazitäten C1, C2 und C3 auf.

Die erfindungsgemäße Überwachungseinrichtung 20 besteht aus dem Isolationsüberwachungsgerät 10, welches über eine Kommunikationsleitung 26 mit einer Auswerteeinheit 24 der Überwachungseinrichtung 20 verbunden ist, den jeweiligen in den Leitungsabgängen 4 angeordneten allstromsensitiven Messstromwandlern 14, die über Signalleitungen 27 mit der Auswerteeinheit 24 verbunden sind, und dem Spannungsmessgerät 22.

Das Isolationsüberwachungsgerät 10 überlagert dem Stromversorgungssystem 2 an einem Einspeisepunkt des Hauptsystems 3 eine Mess-Wechselspannung Um, die - im Fall der Berechnung des Teil-Isolationswiderstands Rx in Signalform der Rechteckimpuls-förmigen Messspannung Uq - einen Gesamt-Messstrom Iges treibt, der sich in die über die Leitungsabgänge 4 fließenden Teilströme I1, I2 und I3 aufteilt.

Die für die Berechnung erforderlichen bzw. zu bestimmenden Größen Ixstat, ix(t), Rx, Cx und ic(t) sind hier beispielhaft dem ersten Leitungsabgang 4 zugeordnet.

Zur Berechnung des Teil-Isolationswiderstands Rx wird zunächst, nachdem die Umladevorgänge der Teil-Netzableitkapazitäten Cx abgeschlossen sind, der stationäre Teilstrom Ixstat im eingeschwungenen Zustand mit dem allstromsensitiven Messstromwandler 14 gemessen. Zusammen mit den von dem Isolationsüberwachungsgerät 10 bekannten Größen Rechteckimpuls-förmige Messspannung Uq und Innenwiderstand Ri und von dem Isolationsüberwachungsgerät 10 übermittelten Gesamt-Isolationswiderstand Rfges wird der Teil-Isolationswiderstand Rx von der Auswerteeinheit 24 ermittelt.

Über den betrachteten Leitungsabgang 4 und damit über der zu ermittelnden Teil-Netzableitkapazität Cx wird mittels des Spannungsmessgerätes 22 der zeitliche Verlauf der nicht stationären Leiter-Erde-Spannung ue(t) gemessen. Zusammen mit dem über den Teil-Isolationswiderstand Rx fließenden (ohmschen) Stromanteil bildet der über die Teil-Netzableitkapazität Cx fließende (kapazitive) Ableitstrom ic(t) den von dem Messstromwandler 14 gemessenen zeitlichen Verlauf des nicht stationären Teilstroms ix(t) während des Einschwingvorgangs. Da somit der Teil-Isolationswiderstand Rx (zuvor ermittelt) sowie ix(t) und ue(t) (aktuell gemessen) bekannt sind, kann der Ableitstrom ic(t) berechnet werden. In Verbindung mit der Bildung der zeitlichen Ableitung der nicht stationären Leiter-Erde-Spannung ue(t) ergibt sich damit die gesuchte Teil-Netzableitkapazität Cx.

**Fig. 3** zeigte ein vereinfachtes Ersatzschaltbild des verzweigten ungeerdeten Stromversorgungssystems 2 mit dem Gesamt-Isolationswiderstand Rfges.

Sämtliche Teil-Isolationswiderstände Rx der Leitungsabgänge 4 sind hier zu dem Gesamt-Isolationswiderstand Rfges zusammengefasst. Durch den von dem Isolationsüberwachungsgerät 10 bereitgestellten Gesamt-Isolationswiderstand Rfges und den bekannten Innenwiderstand Ri des Isolationsüberwachungsgerätes 10 kann der von der bekannten Mess-Wechselspannung Um - in Signalform der Rechteckimpuls-förmigen Messspannung Uq - getriebene Gesamt-Messstrom Iges beschrieben werden.

**Patentansprüche**

**1.** Verfahren zur selektiven Bestimmung eines Teil-Isolationswiderstands Rx eines Leitungsabgangs (4) in einem verzweigten ungeerdeten Stromversorgungssystem (2), das mit einem Isolationsüberwachungsgerät (10) überwacht wird, welches dem ungeerdeten Stromversorgungssystem (2) aktiv eine Rechteckimpuls-förmige Messspannung Uq überlagert, umfassend die Verfahrensschritte:

Berechnen des Teil-Isolationswiderstands Rx gemäß Rx=Ue/Ixstat mit einer über dem Leitungsabgang (4) abfallenden, stationären Leiter-Erde-Spannung Ue und einem in dem Leitungsabgang (4) gemessenen stationären Teilstrom Ixstat im eingeschwungenen Zustand, wobei
für die stationäre Leiter-Erde-Spannung Ue gilt Ue=Iges*Rfges mit einem von dem Isolationsüberwachungsgerät (10) übermittelten Gesamt-Isolationswiderstand Rfges und einem von der bekannten Rechteckimpuls-förmigen Messspannung Uq getriebenen Gesamt-Messstrom Iges, wobei
der Gesamt-Messstrom Iges berechnet wird aus Iges=Uq/(Rfges+Ri) mit einem bekannten Innenwiderstand Ri des Isolationsüberwachungsgerätes (10), sodass der Teil-Isolationswiderstand Rx berechnet wird aus Rx=(Rfges*Uq)/((Rfges+Ri)*Ixstat).

**2.** Verfahren zur selektiven Bestimmung einer Teil-Netzableitkapazität Cx eines Leitungsabgangs (4) in einem verzweigten ungeerdeten Stromversorgungssystem (2), das mit einem Isolationsüberwachungsgerät (10) überwacht wird, welches dem ungeerdeten Stromversorgungssystem (2) aktiv eine Mess-Wechselspannung Um überlagert, umfassend die Verfahrensschritte:

Ermitteln eines Teil-Isolationswiderstand Rx des Leitungsabgangs (4),
Berechnen der Teil-Netzableitkapazität Cx gemäß

$$Cx = ic(t)/(due(t)/dt),$$

mit einem über die Teil-Netzableitkapazität Cx fließenden Ableitstrom ic(t) und einem
zeitlichen Verlauf der über dem Leitungsabgang (4) abfallenden, gemessenen nicht stationären Leiter-Erde-Spannung ue(t), deren zeitliche Ableitung due(t)/dt ist, wobei der Ableitstrom ic(t) berechnet wird aus ic(t)=ix(t)-ue(t)/Rx mit einem zeitlichen Verlauf des in dem Leitungsabgang (4) gemessenen nicht stationären Teilstroms ix(t) und dem ermittelten Teil-Isolationswiderstand Rx,
sodass die Teil-Netzableitkapazität Cx berechnet wird aus

$$Cx = (ix(t)-(ue(t)/Rx))/(due(t)/dt).$$

**3.** Überwachungseinrichtung (20) zur selektiven Bestimmung eines Teil-Isolationswiderstands Rx und einer Teil-Netzableitkapazität Cx eines Leitungsabgangs (4) in einem verzweigten ungeerdeten Stromversorgungssystem (2),

mit einem Isolationsüberwachungsgerät (10), welches konfiguriert ist, dem Stromversorgungssystem (2) aktiv eine Mess-Wechselspannung Um zu überlagern,
**gekennzeichnet durch**
einen allstromsensitiven Messstromwandler (14) zur Messung eines stationären Teilstroms Ixstat und eines nicht stationären Teilstroms ix(t) in jedem zu überprüfenden Leitungsabgang (4),
ein Spannungsmessgerät (22), das zwischen einen aktiven Leiter des ungeerdeten Stromversorgungssystems (2) und Erde (PE) zur Messung des zeitlichen Verlaufs der nicht stationären Leiter-Erde-Spannung ue(t) geschaltet ist und
eine Auswerteeinheit (24), die mit den allstromsensitiven Messstromwandlern (14) und mit dem Isolationsüberwachungsgerät (10) verbunden ist und konfiguriert ist zum Berechnen des Teil-Isolationswiderstands Rx und der Teil-Netzableitkapazität Cx.

**4.** Überwachungseinrichtung nach Anspruch 3,
**dadurch gekennzeichnet,**

**dass** das Isolationsüberwachungsgerät (10) konfiguriert ist, dem Stromversorgungsystem (2) als Mess-Wechselspannung Um zum Berechnen des Teil-Isolationswiderstands Rx eine Rechteckimpuls-förmige Messspannung Uq zu überlagern.

5.  Überwachungseinrichtung nach Anspruch 3 oder 4,
    **dadurch gekennzeichnet,**
    **dass** die Messstromwandler (14) installierte Messstromwandler (14) einer Isolationsfehlersucheinrichtung (12) sind.

6.  Überwachungseinrichtung nach einem der Ansprüche 3 bis 5,
    **dadurch gekennzeichnet,**
    **dass** die Auswerteeinheit (24) ein Auswertegerät (23) einer Isolationsfehlersucheinrichtung ist.

## Claims

1.  A method for selectively determining a partial insulation resistance Rx of an outgoing line (4) in a branched ungrounded power supply system (2) which is monitored using an insulation monitoring device (10) which actively superposes a square pulse measuring voltage Uq on the ungrounded power supply system (2), the method comprising the following steps:

    calculating partial insulation resistance Rx according to Rx = Ue/Ixstat with a stationary conductor-to-ground voltage Ue dropping via the outgoing line (4) and a stationary partial current Ixstat measured in the outgoing line (4) in a settled state, wherein
    Ue = Iges*Rfges applies to stationary conductor-to-ground voltage Ue with a total insulation resistance Rfges transmitted by the insulation monitoring device (10) and a total measuring current Iges driven by known square pulse measuring voltage Uq, wherein
    total measuring current Iges is calculated from Iges = Uq/(Rfges+Ri) with a known inner resistance Ri of the insulation monitoring device (10), meaning partial insulation resistance Rx is calculated from

$$Rx = (Rfges*Uq)/((Rfges+Ri)*Ixstat).$$

2.  A method for selectively determining a partial system leakage capacitance Cx of an outgoing line (4) in a branched ungrounded power supply system (2) which is monitored using an insulation monitoring device (10) which actively superposes a measuring alternating voltage Um on the ungrounded power supply system (2), the method comprising the following steps:

    determining a partial insulation resistance Rx of the outgoing line (4),
    calculating partial system leakage capacitance Cx according to

$$Cx = ic(t)/(due(t)/dt),$$

    with a leakage current ic(t) flowing via partial system leakage capacitance Cx and a temporal development of measured non-stationary conductor-to-ground voltage ue(t) which drops via the outgoing line (4) and whose temporal derivative is due(t)/dt, leakage current ic(t) being calculated from ic(t) = ix(t)-ue(t)/Rx with a temporal development of non-stationary partial current ix(t) measured in the outgoing line (4) and determined partial insulation resistance Rx,
    meaning partial system leakage capacitance Cx is calculated from

$$Cx = (ix(t)-(ue(t)/Rx))/(due(t)/dt).$$

3.  A monitoring device (20) for selectively determining a partial insulation resistance Rx and a partial system leakage capacitance Cx of an outgoing line (4) in a branched ungrounded power supply system (2),

    having an insulation monitoring device (10) which is configured to actively superpose a measuring alternating voltage Um on the power supply system (2),

**characterized by**
an AC/DC measuring current transformer (14) for measuring a stationary partial current Ixstat and a non-stationary partial current ix(t) in each outgoing line (4) to be tested,
a voltage measuring device (22) which is connected between an active conductor of the ungrounded power supply system (2) and ground (PE) for measuring the temporal development of non-stationary conductor-to-ground voltage ue(t), and
an evaluation unit (24) which is connected to the AC/DC measuring current transformer (14) and to the insulation monitoring device (10) and is configured for calculating partial insulation resistance Rx and partial system leakage capacitance Cx.

4. The monitoring device according to claim 3,
   **characterized in that**
   the insulation monitoring device (10) is configured to superpose a square pulse measuring voltage Uq on the power supply system (2) as a measuring alternating voltage Um for calculating the partial insulation resistance Rx.

5. The monitoring device according to claim 3 or 4,
   **characterized in that**
   the measuring current transformers (14) are installed measuring current transformers (14) of an insulation fault location device (12).

6. The monitoring device according to any one of the claims 3 to 5, **characterized in that**
   the evaluation unit (24) is an evaluation apparatus (23) of an insulation fault location device.

**Revendications**

1. Procédé pour déterminer sélectivement une résistance d'isolation partielle Rx d'une ligne de sortie (4) dans un système d'alimentation électrique (2) non mis à la terre ramifié qui est surveillé par un dispositif de surveillance d'isolation (10) qui superpose activement une tension de mesure Uq en forme d'impulsion rectangulaire sur le système d'alimentation électrique (2) non mis à la terre, le procédé comprenant les étapes consistant à :

   calculer la résistance d'isolation partielle Rx selon Rx = Ue/Ixstat avec une tension phase-terre stationnaire Ue baissant en amont de la ligne de sortie (4) et un courant partiel stationnaire Ixstat mesuré dans la ligne de sortie (4) dans l'état stabilisé,
   dans lequel
   Ue = Iges * Rfges s'applique à la tension phase-terre stationnaire Ue avec une résistance d'isolation totale Rfges transmise par le dispositif de surveillance d'isolation (10) et un courant de mesure total Iges entraîné par la tension de mesure Uq en forme d'impulsion rectangulaire connue, dans lequel le courant de mesure total Iges est calculé selon Iges = Uq/(Rfges + Ri) avec une résistance interne Ri connue du dispositif de surveillance d'isolation (10), de sorte que la résistance d'isolation partielle Rx est calculée selon

$$Rx = (Rfges * Uq)/((Rfges + Ri) * Ixstat).$$

2. Procédé pour déterminer sélectivement une capacité de fuite de réseau partielle Cx d'une ligne de sortie (4) dans un système d'alimentation électrique (2) non mis à la terre ramifié qui est surveillé par un dispositif de surveillance d'isolation (10) qui superpose activement une tension alternative de mesure Um sur le système d'alimentation électrique (2) non mis à la terre, le procédé comprenant les étapes consistant à :

   déterminer une résistance d'isolation partielle Rx de la ligne de sortie (4),
   calculer la capacité de fuite de réseau partielle Cx selon Cx = ic(t)/(due(t)/dt) avec un courant de fuite ic(t) passant par la capacité de fuite de réseau partielle Cx et un déroulement temporel de la tension phase-terre non stationnaire ue(t) mesurée qui baisse en amont de la ligne de sortie (4) et dont la dérivée temporelle est due(t)/dt, le courant de fuite ic(t) étant calculé selon ic(t) = ix(t) - ue(t)/Rx avec un déroulement temporel du courant partiel non stationnaire ix(t) mesuré dans la ligne de sortie (4) et
   la résistance d'isolation partielle Rx déterminée,
   de sorte que la capacité de fuite de réseau partielle Cx est calculée selon Cx = (ix(t) - (ue(t)/Rx))/(due(t)/dt).

**3.** Dispositif de surveillance (20) pour déterminer sélectivement une résistance d'isolation partielle Rx et une capacité de fuite de réseau partielle Cx d'une ligne de sortie (4) dans un système d'alimentation électrique (2) non mis à la terre ramifié,

le dispositif de surveillance (20) comprenant un dispositif de surveillance d'isolation (10) qui est configuré pour superposer activement une tension alternative de mesure Um sur le système d'alimentation électrique (2), **caractérisé par**
un transformateur de courant de mesure AC/DC (14) pour mesurer un courant partiel stationnaire Ixstat et un courant partiel non stationnaire ix(t) dans chaque ligne de sortie (4) à tester,
un dispositif de mesure de tension (22) qui est connecté entre un conducteur actif du système d'alimentation électrique (2) non mis à la terre et la terre (PE) pour mesurer le déroulement temporel de la tension phase-terre non stationnaire ue(t), et
une unité d'évaluation (24) connectée au transformateur de courant de mesure AC/DC (14) et au dispositif de surveillance d'isolation (10) et configurée pour calculer la résistance d'isolation partielle Rx et la capacité de fuite de réseau partielle Cx.

**4.** Dispositif de surveillance selon la revendication 3, **caractérisé en ce que**
le dispositif de surveillance d'isolation (10) est configuré pour superposer une tension de mesure Uq en forme d'impulsion rectangulaire sur le système d'alimentation électrique (2) comme tension alternative de mesure Um pour calculer la résistance d'isolation partielle Rx.

**5.** Dispositif de surveillance selon la revendication 3 ou 4, **caractérisé en ce que**
les transformateurs de courant de mesure (14) sont des transformateurs de courant de mesure (14) installés d'un dispositif de localisation de défauts d'isolation (12).

**6.** Dispositif de surveillance selon l'une quelconque des revendications 3 à 5,
**caractérisé en ce que**
l'unité d'évaluation (24) est un appareil d'évaluation (23) d'un dispositif de localisation de défauts d'isolation.

Fig. 1

**Fig. 2**

**Fig. 3**

EP 4 246 150 B1

**IN DER BESCHREIBUNG AUFGEFÜHRTE DOKUMENTE**

**In der Beschreibung aufgeführte Patentdokumente**

- DE 102017217473 B3